# EUROPEAN PATENT APPLICATION

(11) **EP 2 843 696 A1**
(43) Date of publication of application: **04.03.2015**
(21) Application number: 13181803.1
(22) Date of filing: 27.08.2013
(51) Int. Cl.: H01L 21/8234, H01L 21/8238

(54) **A method for dopant implantation of FinFET structures**

(71) Applicant: IMEC VZW, 3001 Leuven (BE)
(72) Inventor: Paraschiv, Vasile, 3001 Leuven (BE); Winroth, Gustaf, 3001 Leuven (BE); Altamirano Sanchez, Efrain, 3001 Leuven (BE); Locorotondo, Sabrina, 3001 Leuven (BE); Athimulam, Raja, 3001 Leuven (BE)
(74) Representative: Clerix, André

(57) **Abstract**

The present invention is related to a method for implanting dopant elements in a structure comprising a plurality of semiconductor fins (1) separated by field dielectric areas (2), the method comprising the steps of depositing a BARC layer (4) on said fins, depositing a resist layer (5) on said BARC layer, removing a portion of said resist layer by lithography steps, thereby exposing an area of the BARC layer, removing the BARC layer in said area by a dry etch process using the remaining resist layer as a mask, implanting dopant elements into the fins present in said area, using the BARC and resist layers as a mask, removing the remainder of said resist and BARC layers, characterized in that the method comprises the additional step of depositing an etch stop layer (3) directly on said fins (1), before the steps of depositing a BARC layer (4) and a resist layer (5).

## Description

### Field of the Invention

The present invention is related to the production of integrated circuits (ICs) provided with fin-shaped structures.

### State of the art

FinFET technology has been one of the main avenues for increasing the device density on an IC. The topography represented by the fin-structures however poses new challenges in various domains, notably in the area of lithography. Layers in an IC stack that need to be patterned on a stack with topography cannot easily be printed by photolithography without optical reflection control. In addition, for stringent control of critical dimensions (CDs), a planarising layer is needed for good profile control throughout the resist layer. A common planarising layer is a polymeric material that can be spin cast from solvent and that can be used simultaneously as a coating for reflection control. Such coatings are commonly called Bottom Anti-Reflective Coatings, or BARCs.

The BARC needs to be subsequently etched in order to open and transfer the patterns down to the substrate for further processing. A very common application is patterning ion implantation layers, where the photoresist and BARC together constitute the implantation mask. In this case, the BARC etch opening and over-etch, which clears the BARC around the fins, cannot be allowed to consume or damage the underlying topography.

These problems have become more prominent with the development of lithography from the 248nm wavelength technology to the 193nm wavelength technology, which is becoming the new norm due to the ever decreasing device dimensions. 193nm lithography requires specific dimensions and materials of the resist and BARC layers, which can only be adequately etched by dry etching. This on the other hand limits the available etch chemistries suitable for removing the BARC without damaging the fins.

### Summary of the invention

The invention is related to a method which overcomes the above-described problems. The method of the invention is disclosed in the appended claims.

The present invention is thus related to a method for implanting dopant elements in a structure comprising a plurality of semiconductor fins separated by field dielectric areas, the method comprising the steps of depositing a BARC layer on said fins, depositing a resist layer on said BARC layer, removing a portion of said resist layer by lithography steps, thereby exposing an area of the BARC layer, removing the BARC layer in said area by a dry etch process using the remaining resist layer as a mask, implanting dopant elements into the fins present in said area, thereby using the BARC and resist layers as a mask, removing the remainder of said resist and BARC layers, **characterized in that** the method comprises the additional step of depositing an etch stop layer directly on said fins, before the steps of depositing a BARC layer and a resist layer. The etch stop layer protects the fins during the BARC removal step, so that the latter step can be performed using dry etch techniques that would otherwise have damaged the fins.

The etch stop layer is preferably a thin layer applied by Atomic Layer Deposition, the layer being conformal to the fin topography. According to an embodiment, the ion implantation can be done through the thin layer, thereby obviating the need for a removal step of the etch stop layer in the specific areas where the dopant implant is required.

According to an embodiment, the thickness of the etch stop layer is between 2 and 5nm. The lithography steps are preferably performed using 193nm lithography technology.

According to an embodiment, the etch stop layer comprises a high-k dielectric material comprising Al, Ti or Hf. Preferably, said high-k dielectric material is chosen from the group consisting of Al₂O₃, AlN, TiN or HfO₂

### Brief description of the figures

Figures 1a to 1e illustrate the basic steps of the method according to one embodiment of the invention.

Figure 2 illustrates an alternative method step.

### Detailed description of the invention

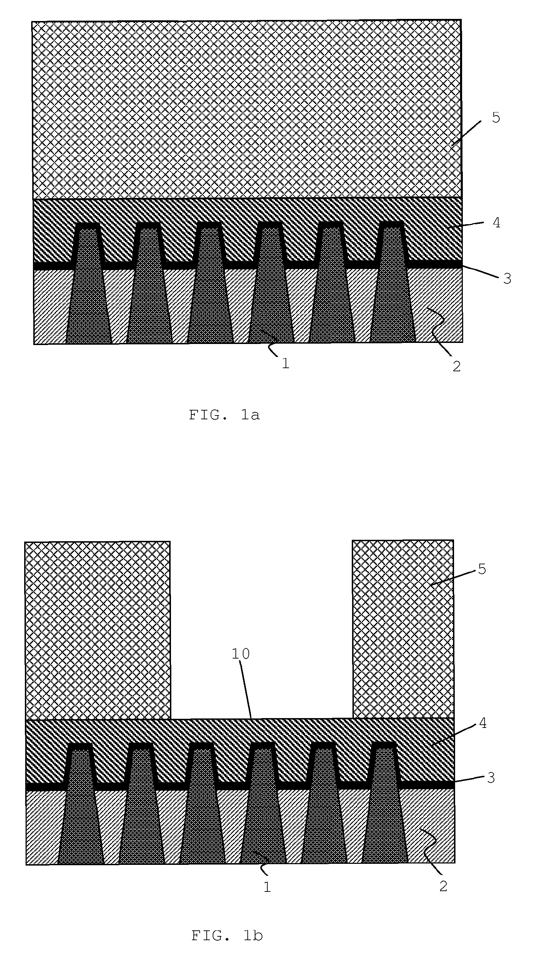

As shown in figure 1a, the method of the invention is applied on a fin-structure comprising a plurality of semiconductor fins 1, e.g. silicon fins, arranged in an array of fins which are separated by a field dielectric 2, e.g. SiO₂. These fins are built on an underlying support wafer, not shown in the drawings for the sake of simplicity. The manner in which this structure may be obtained is known as such to the skilled reader and is therefore not described here in detail. A dopant implantation step is required in a restricted area of the fin array, for example for the creation of HALO/HDD implants. This is what will be accomplished by the steps described hereafter.

In a first step, a thin dielectric layer 3 is deposited on the fins, preferably having a thickness that is suitable for forming a conformal layer, i.e. a layer that follows the topography of the fins, as illustrated in the drawing. This layer is preferably produced by Atomic Layer Deposition (ALD), and will hereafter be referred to as the 'ALD layer', even though it is not excluded that the layer may be applied by other methods. The ALD layer is the focus of the present invention, in that it will play the part of an etch stop layer in a further step of the method, as will be explained further on. The ALD layer 3 may be an Al₂O₃ layer for example. According to an embodiment, the top width of the fins is in the order of 10nm (e.g. between 5 and 20nm with the pitch of the array between 30nm and 60nm) and the thickness of the ALD-layer 3 is between 2 and 5 nm.

Then, a BARC layer 4 (as defined above) and a layer of photoresist 5 are subsequently deposited on top of the fin topography. The thickness and material choice of the BARC are preferably suitable for lithography according to the 193nm technology. For example, the BARC may be a layer of PMMA (Polymethylmethacrylate) between 100 and 180nm thick, or any other material suitable for acting as a BARC, as known in the art, e.g. as described in "New 193nm Bottom Anti-Reflective Coating", Nakayama et al., Proceedings of SPIE Vol. 5039 (2003). The resist layer 5 may be formed of a chemically amplified methacrylate-based resist, with a thickness ranging between 100nm and 400nm. The BARC and resist may be deposited by a suitable method known as such in the art, for example by a spin-on deposition followed by a baking step.

In the next step illustrated in figure 1b, an area 10 is defined wherein a dopant implant is to be performed (in practice an array of such areas 10 is defined, aligned with the fin topography). The definition of the area 10 is done by removing a portion of the resist 5. This is achieved by the standard steps of masking the resist, illuminating the exposed portions, developing the resist and removing the resist from the area in question. This leads to the situation shown in figure 1b, with an area 10 of the BARC 4 exposed, while the rest of the BARC remains covered by resist material 5.

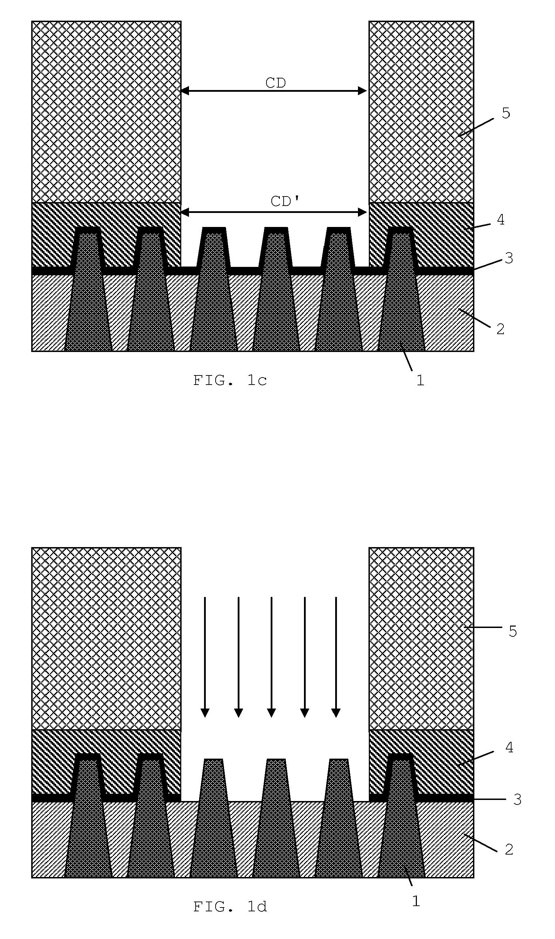

As illustrated in figure 1c, the BARC is then removed in said area 10 by a plasma etch with a suitable etch chemistry that allows the BARC to be etched anisotropically, i.e. with essentially no lateral etching underneath the resist 5, so that the critical dimension CD is essentially maintained after removal of the BARC, i.e. CD is essentially equal to CD' (see figure 1c). When the BARC is made of PMMA, this may be achieved by plasma etching in a fluorine based plasma with highly polymerizing gases like CH₂F₂ or CH₃F.

The ALD layer 3 acts as an etch stop layer in the BARC removal etch process, i.e. the ALD layer ensures that the fins 1 are not attacked by the BARC removal etch. Preferred materials of the ALD layer that are suitable for this purpose are high K dielectrics such as Al₂O₃, Hf-oxide or AlN.

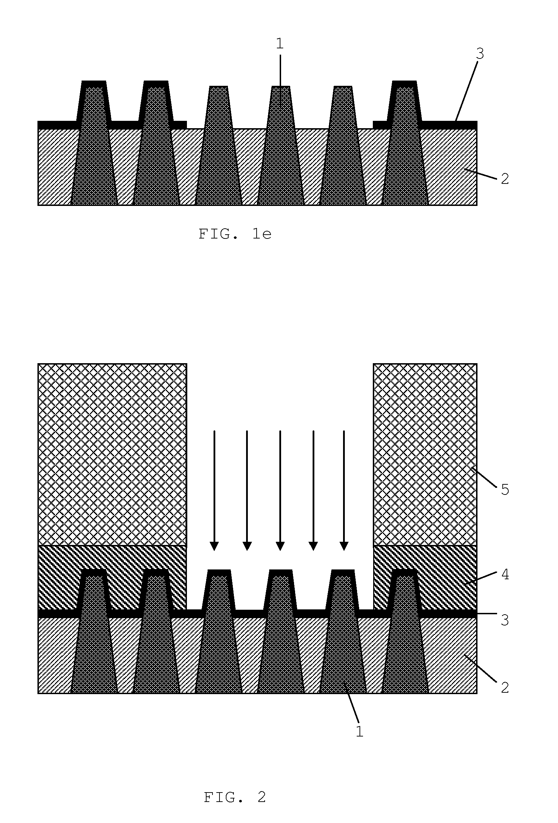

According to the embodiment illustrated in figure 1d, the ALD layer is removed from the area 10, after which the dopant implant step (illustrated by the vertical arrows in figure 1d) is performed, using the resist 5 and BARC 4 as an implant mask so that dopants are implanted only in area 10 of the fin topography. After that, the resist and BARC are stripped (figure 1e). The remainder of the ALD layer 3 is then removed from the rest of the fin array. The removal of the ALD layer 3 from area 10 before dopant implantation as well as the removal of the remainder of the ALD layer after dopant implantation and resist+BARC strip may be done for example by a diluted HF solution or by an isotropic dry etch process with high selectivity towards the fins 1 and the field dielectric areas 2.

According to another embodiment (see figure 2), the dopant implant is done without removing the ALD layer 3 from the area 10, i.e. dopant elements are implanted through the ALD layer 3. This is possible only when the ALD layer is sufficiently thin to allow dopant implantation through the layer. This may for example be achieved by a 2nm thick Al₂O₃ layer deposited on silicon fins. After the implant step, the resist and BARC are stripped, and the ALD layer 3 is removed from the totality of the fin-array (again e.g. by HF or dry etch).

### Example of process parameters

Silicon bulk fin wafers with 30 nm high topography and a 100 nm deep field oxide are used as substrates in the ALD process, where 5 nm Al₂O₃ is deposited conformally over the fins. The fin pitch is 45 nm and the fin width is 8 nm on top and 10 nm at the field oxide surface.

The BARC layer is a 30nm thick layer of ARC95 (product name of material from company AMC) is spin cast at 2500 rpm, which corresponds to a 30 nm thickness on blanket Si-wafers. There is a subsequent bake of 205 °C in order to cross-link the layer, such as to make it insoluble to the casting solvent. This is necessary since the resist is spin cast on top from a similar solvent, i.e. an ester-like solvent. The resist (JSR ARX3500 from company JSR NV) is spin cast at 1500 rpm to a final thickness of 230 nm. There is a post-apply bake of 100°C for 60 seconds. Both the BARC and resist spincasting as well as the post-apply bakes are performed sequentially in an automated program on an ACT 12 wafer track from Tokyo Electron Ltd (TEL™). After each bake step, the wafers are cooled down to ambient air temperature (22 °C) for at least 60 seconds.

The wafer track is interfaced with the lithographic scanner, which is here a Twinscan™ XT1250D from ASML. The exposures are targeted to resolve a 200 nm wide space pattern in a 400 nm pitch line-space grating, which is aligned over the fin topography of the substrate (i.e. the width CD in figure 1c is 200nm and an array with a pitch of 400nm of such areas 10 is aligned with the fin topography). After exposure, the wafers are ported back to the same track for post-exposure bakes (130 °C) and development in a 0.262N TMAH (Tetramethylammonium hydroxide) puddle for 60 seconds.

The BARC etch is performed in a LAM Kiyo® 3C chamber using a Chlorine based chemistry, which clears out all the organic material (BARC) from the topography and completely exposes the Al₂O₃ in the trench.

The wafer is then implanted through the Al₂O₃ layer with Arsenic ions at a set kinetic energy of 2 keV in an Applied Materials Quantum®X ion implantation tool. The final dose is 1e15 cm⁻².

The resist and BARC is then stripped in the LAM Kiyo® 3C chamber using an oxygen based chemistry. Once cleared from the organic residues of the resist and BARC, the Al₂O₃ can be easily removed selectively to the substrate by a wet process using a diluted HCl and ammonium peroxide solutions.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A method for implanting dopant elements in a structure comprising a plurality of semiconductor fins (1) separated by field dielectric areas (2), the method comprising the steps of :
• depositing a BARC layer (4) on said fins,
• depositing a resist layer (5) on said BARC layer,
• removing a portion of said resist layer by lithography steps, thereby exposing an area (10) of the BARC layer,
• removing the BARC layer in said area (10) by a dry etch process using the remaining resist layer as a mask,
• implanting dopant elements into the fins present in said area (10), using the BARC and resist layers as a mask,
• removing the remainder of said resist and BARC layers, **characterized in that** the method comprises the additional step of depositing an etch stop layer (3) directly on said fins (1), before the steps of depositing a BARC layer (4) and a resist layer (5).

2. Method according to claim 1, wherein said etch stop layer (3) is removed in said area (10) before the step of implanting dopant elements.

3. Method according to claim 1, wherein said etch stop layer (3) is not removed in said area (10) before the step of implanting dopant elements, and wherein said dopant elements are implanted through said etch stop layer (3).

4. Method according to any one of the preceding claims, wherein said etch stop layer (3) is a conformal layer that follows the topography defined by said semiconductor fins (1).

5. Method according to claim 4, wherein the thickness of said etch stop layer (3) is between 2 and 5nm.

6. Method according to any one of the preceding claims wherein said etch stop layer (3) is deposited by atomic layer deposition (ALD).

7. Method according to any one of the preceding claims, wherein said lithography steps are performed using 193nm lithography technology.

8. Method according to any one of the preceding claims wherein said etch stop layer (3) comprises a high-k dielectric material comprising Al, Ti or Hf.

9. Method according to claim 8, wherein the high-k dielectric material is chosen from the group consisting of Al₂O₃, AlN, TiN or HfO₂.
